# FASCICULE DE BREVET EUROPEEN

(11) **EP 3 263 982 B1**
(45) Date de publication et mention de la délivrance du brevet: **10.04.2019**
(21) Numéro de dépôt: 17176552.2
(22) Date de dépôt: 19.06.2017
(51) Int. Cl.: F21V 21/08, G09F 9/30, H01L 51/52, H01L 51/00, H01L 27/32, B32B 37/12, B32B 37/14, B32B 37/18, B32B 37/26, B64D 47/00, B64C 1/00

(54) **PROCEDE POUR REALISER UNE MARQUE ELECTROLUMINESCENTE SUR UNE PAROI EXTERIEURE D'UN AERONEF, BANDE DE MARQUAGE COMPRENANT LADITE MARQUE ELECTROLUMINESCENTE ET AERONEF COMPRENANT LADITE MARQUE ELECTROLUMINESCENTE**
VERFAHREN ZUR HERSTELLUNG EINER ELEKTROLUMINESZENZMARKIERUNG AUF EINER AUSSENWAND EINES LUFTFAHRZEUGS, MARKIERUNGSBAND, DAS DIESE ELEKTROLUMINESZENZMARKIERUNG UMFASST, UND LUFTFAHRZEUG, DAS DIESE ELEKTROLUMINESZENZMARKIERUNG UMFASST
METHOD FOR MAKING A LIGHT-EMITTING MARK ON AN OUTER WALL OF AN AIRCRAFT, MARKING BAND COMPRISING SAID LIGHT-EMITTING MARK AND AIRCRAFT COMPRISING SAID LIGHT-EMITTING MARK

(30) Priorité: 29.06.2016 FR 1656112
(43) Date de publication de la demande: 03.01.2018
(73) Titulaire: Airbus Operations S.A.S., 31060 Toulouse (FR); Airbus (S.A.S.), 31700 Blagnac (FR)
(72) Inventeur: LOUBIERE, Vincent, 31000 TOULOUSE (FR); COURTADON, Alix, 31000 TOULOUSE (FR); TRINGHAM, Matthew, 31300 TOULOUSE (FR)
(74) Mandataire: Gicquel, Olivier Yves Gérard

(56) Documents cités:
- FR-A1- 3 002 206
- US-A1- 2003 134 488
- US-A1- 2008 142 238
- US-A1- 2015 083 190
- US-A1- 2016 042 675

## Description

La présente demande se rapporte à un procédé pour réaliser une marque électroluminescente sur une paroi extérieure d'un aéronef, à une bande de marquage comprenant ladite marque électroluminescente ainsi qu'à un aéronef comprenant ladite marque électroluminescente. Une paroi extérieure d'un aéronef comprend au moins une marque comme par exemple un numéro d'immatriculation. Selon un mode de réalisation, cette marque est électroluminescente pour rester visible la nuit ou lorsque les conditions climatiques ne sont pas favorables.

Le document US-8.470.388 propose une solution pour réaliser une marque électroluminescente sur un support qui peut être une paroi extérieure d'un aéronef.

Selon ce document, le procédé de marquage comprend une première étape de dépose d'une première couche isolante sur la paroi extérieure de l'aéronef, une deuxième étape de dépose d'une deuxième couche de peinture conductrice, une troisième étape de dépose d'une troisième couche électroluminescente, une quatrième étape de mise en place d'une électrode d'alimentation positionnée sur le pourtour de la couche électroluminescente, une cinquième étape de dépose d'une quatrième couche conductrice transparente et une sixième étape de dépose d'une cinquième couche de protection tel qu'un vernis.

Ces différentes étapes sont réalisées les unes à la suite des autres sur l'aéronef. Compte tenu du temps de réalisation et de séchage de ces différentes couches, ce procédé de marquage a un impact très important sur la cadence de production d'un aéronef.

Pour rendre luminescente la marque ainsi apposée, la deuxième couche de peinture conductrice et l'électrode d'alimentation sont reliées par un réseau filaire à un système d'alimentation et de commande électrique positionné à l'intérieur de l'aéronef. A cet effet, la paroi extérieure de l'aéronef comprend au moins un orifice, généralement deux orifices, positionné(s) autour ou proche de la marque électroluminescente pour permettre le passage du réseau filaire. De tels orifices sont également divulgués dans les documents US2008/14/2238 et US2016/042675. Lorsque la marque est disposée sur une surface soumise au flux d'air (par exemple, sur une paroi du fuselage), l'opération de perçage modifie la surface de l'aéronef qui est soumise à un flux d'air et dégrade les performances aérodynamiques de l'aéronef. De même, la présence d'un réseau filaire sur la surface de l'aéronef perturbe l'écoulement du flux d'air et les performances de l'aéronef.

Le document US2015/083190 propose une méthode de fabrication de panneaux photovoltaïques destinés à être positionnés sur un fuselage d'un avion commercial. De tels panneaux comportent une couche de fixation, des cellules photovoltaïques supportées par une couche flexible et une couche de protection en dur. Des câbles et des contacts électriques sont contenus dans le corps de l'avion. Le document US2003/134488 propose une méthode de fabrication d'un dispositif semi-conducteur à base d'un matériau organique comportant plusieurs couches appliquées sur une surface courbée. Un tel dispositif comporte une superposition de couches. Le document FR3002206 divulgue un dispositif d'affichage comportant un film électronique apte à être fixé sur la partie externe d'un engin mobile, ledit film étant alimenté par une source d'alimentation électrique qui peut être une source usuelle existant déjà sur l'engin mobile ou un film photovoltaïque se trouvant sur une surface adéquate de l'engin mobile. L'affichage sur le film électronique se fait à partir de d'une unité de commande intégré dans le calculateur embarqué de l'engin mobile.

L'ensemble de ces solutions existantes perturbent l'écoulement du flux d'air sur le fuselage de l'aéronef et détériorent les performances de l'aéronef.

La présente invention vise à remédier aux inconvénients de l'art antérieur.

A cet effet, l'invention a pour objet un procédé pour réaliser une marque électroluminescente sur une paroi extérieure d'un aéronef, ladite paroi extérieure comprenant un panneau avec une face extérieure et une face intérieure et étant délimité par un bord. Le procédé comprend une étape de superposition de couches configurées pour réaliser la marque électroluminescente sur une première face d'un support souple distinct de l'aéronef pour obtenir une bande de marquage, et une étape d'apposition de la bande de marquage sur la paroi extérieure de l'aéronef et une étape d'apposition d'au moins une bande de connexion sur la face extérieure du panneau jusqu'au bord du panneau pour relier la marque électroluminescente à un système d'alimentation et de commande électrique positionné à l'intérieur de l'aéronef, le bord du panneau étant disposé en aval par rapport à la marque électroluminescente selon la direction d'écoulement d'un flux d'air qui s'écoule à l'extérieur de l'aéronef lorsque l'aéronef est en vol.

Dans un premier mode de réalisation de l'invention, la bande de connexion s'étend, sur la face extérieure du panneau, de la bande de marquage jusqu'au bord du panneau, et sur la face intérieure du panneau, du bord jusqu'à un point décalé par rapport au bord.

Dans un deuxième mode de réalisation de l'invention, la bande de marquage comprend une deuxième face adhésive configurée pour être plaquée contre la paroi extérieure et en ce que le procédé comprend une étape de dépose d'un film de protection contre la deuxième face adhésive et une étape de retrait du film de protection avant l'étape d'apposition.

La marque électroluminescente est réalisée sur un support souple indépendant de l'aéronef et non directement sur l'aéronef. Ainsi, la marque électroluminescente est apposée sur l'aéronef en une seule étape dont la durée est limitée. L'invention a également pour objet un aéronef comprenant un dispositif de marquage comportant une bande de marquage comprenant une marque électroluminescente. La bande de marquage comprend un support souple avec une première face qui comporte une superposition de couches configurées pour réaliser la marque électroluminescente et une deuxième face configurée pour être plaquée contre une face extérieure d'un panneau d'une paroi extérieure de l'aéronef ainsi qu'une extension configurée pour s'étendre sur la face extérieure du panneau jusqu'à un bord du panneau afin de relier la marque électroluminescente à un système d'alimentation et de commande électrique positionné à l'intérieur de l'aéronef, le bord du panneau étant disposé en aval par rapport à la marque électroluminescente selon la direction d'écoulement d'un flux d'air qui s'écoule à l'extérieur de l'aéronef lorsque l'aéronef est en vol.

Dans un premier mode de réalisation de l'invention, l'extension est configurée pour s'étendre, sur la face extérieure du panneau, de la bande de marquage jusqu'au bord du panneau, et sur la face intérieure du panneau, du bord jusqu'à un point décalé par rapport au bord.

Dans un deuxième mode de réalisation de l'invention, la deuxième face est adhésive et en ce que la bande de marquage comprend un film de protection recouvrant la deuxième face adhésive.

Dans un troisième mode de réalisation de l'invention, le dispositif de marquage comprend au moins une bande de connexion pour relier la bande de marquage à un système d'alimentation et de commande électrique positionné à l'intérieur de l'aéronef, ladite bande de connexion étant configurée pour s'étendre sur la face extérieure du panneau, de la bande de marquage jusqu'à un bord du panneau.

Dans un mode de réalisation, le dispositif de marquage comprend au moins une première et une deuxième bandes de connexion comprenant chacune au moins un conducteur électrique et une bande de raccordement disposée à cheval sur les première et deuxième bandes de connexion de manière à relier les éléments conducteurs desdites première et deuxième bandes de connexion.

D'autres caractéristiques et avantages ressortiront de la description qui va suivre de l'invention, description donnée à titre d'exemple uniquement, en regard des dessins annexés sur lesquels :
- La figure 1 est une vue latérale d'un aéronef comprenant une marque électroluminescente,
- La figure 2 est une vue de face d'un panneau d'un aéronef comprenant une marque électroluminescente qui illustre un mode de réalisation de l'invention,
- La figure 3 est une coupe selon la ligne III-III du panneau visible sur la figure 2,
- La figure 4 est une coupe selon la ligne IV-IV de la figure 2 d'une bande de marquage comprenant une marque électroluminescente apposée sur un panneau qui illustre un mode de réalisation de l'invention,
- La figure 5 est une coupe selon la ligne V-V de la figure 2 d'une bande de connexion apposée sur un panneau qui illustre un mode de réalisation de l'invention,
- La figure 6 est une coupe de la bande de marquage visible sur la figure 4 avant son apposition sur un panneau,
- La figure 7 est une coupe de la bande de connexion visible sur la figure 5 avant son apposition sur un panneau,
- La figure 8 est une vue de face d'un panneau d'un aéronef comprenant une marque électroluminescente qui illustre un autre mode de réalisation de l'invention,
- La figure 9 est une coupe selon la ligne IX-IX de la figure 8.

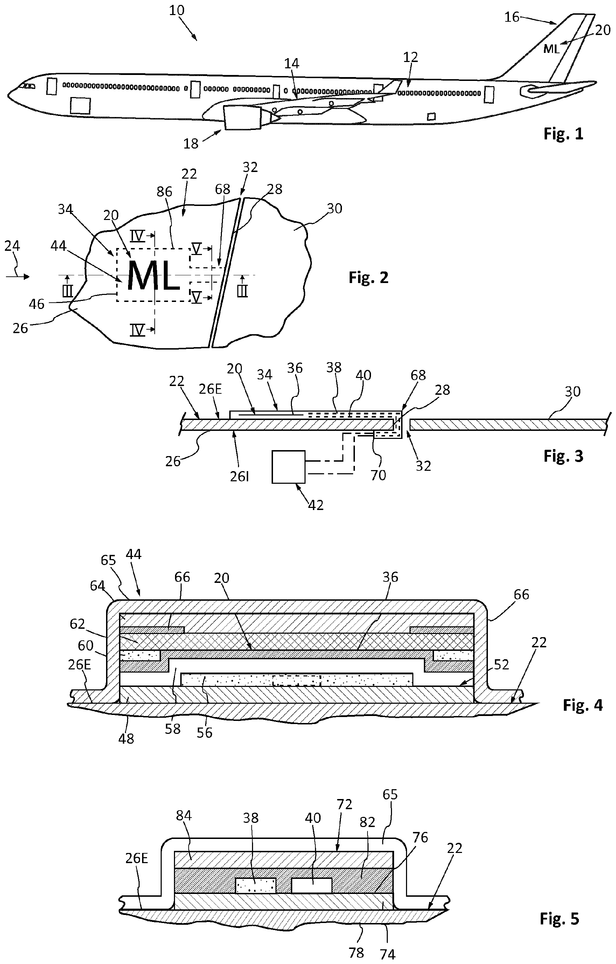

Sur la figure 1, on a représenté un aéronef 10 qui comprend entre autre un fuselage 12, une voilure 14, un empennage 16, des nacelles 18.

Selon une configuration visible sur la figure 1, l'aéronef 10 comprend une marque électroluminescente 20 positionnée sur l'empennage 16.

Bien entendu, l'invention n'est pas limitée à cette position pour la marque électroluminescente 20. Ainsi, comme illustré sur les figures 1 et 2, la marque 20 est apposée sur une paroi extérieure 22.

Selon un mode de réalisation, la marque électroluminescente 20 comprend au moins un caractère alphanumérique. Selon l'exemple illustré sur les figures 1 et 2, la marque électroluminescente 20 comprend deux lettres « M » et « L ». Bien entendu, l'invention n'est pas limitée à ce type de marque, la marque électroluminescente peut être un décor.

Pour la suite de la description, une paroi extérieure 22 est une paroi de l'aéronef en contact avec un flux d'air 24 qui s'écoule à l'extérieur de l'aéronef en vol. Ce flux d'air 22 est représenté sous la forme d'une flèche sur la figure 2 qui indique la direction d'écoulement du flux d'air 24.

A titre d'exemple et de manière non limitative, la paroi extérieure 22 peut être une partie du fuselage 12, de la voilure 14, de l'empennage 16 ou d'une des nacelles 18 de l'aéronef.

Selon un mode de réalisation visible sur les figures 2 et 3, cette paroi extérieure 22 comprend au moins un panneau 26 avec une face extérieure 26E et une face intérieure 26I. Ce panneau 26 comprend au moins un bord 28. Selon une configuration, la paroi extérieure 22 comprend, en plus du panneau 26, au moins un élément structurel 30 qui jouxte le panneau 26 au niveau du bord 28. Selon les cas, cet élément structurel 30 peut être un autre panneau, un cadre de hublot ou autre. Le panneau 26 et l'élément structurel 30 sont séparés par un interstice 32.

Selon une configuration, le bord 28 est disposé en aval par rapport à la marque électroluminescente 20 selon la direction d'écoulement du flux d'air 24.

Pour obtenir la marque électroluminescente 20 sur la paroi extérieure 22, un dispositif de marquage 34 est apposé sur la face extérieure 26E du panneau 26.

Ce dispositif de marquage 34 comprend au moins une bande de marquage 44 comprenant un support souple 48 avec une première face 52 qui supporte au moins une couche électroluminescente 36 reliée par un premier conducteur électrique 38 et un deuxième conducteur électrique 40 à un système d'alimentation et de commande électrique 42 positionné à l'intérieur de l'aéronef 10. Le nombre de couches électroluminescentes 36 et leurs formes sont déterminés en fonction de la marque électroluminescente 20 souhaitée. Une deuxième face 54 du support souple 48 est configurée pour être plaquée contre la face extérieure 26E du panneau 26.

La marque électroluminescente 20 comprend une couche de protection 65 transparente (visible sur les figures 4 et 5) recouvrant le dispositif de marquage 34 et une portion de la face extérieure 26E du panneau extérieur 26.

Selon un mode de réalisation visible sur la figure 4, la bande de marquage 44 comprend, sur la première face 52, une superposition de couches qui comporte à partir de la première face 52 :
- une première couche conductrice 56,
- une couche diélectrique 58,
- la couche électroluminescente 36,
- au moins une électrode d'alimentation 60 positionnée sur au moins une portion du pourtour de la couche électroluminescente 36,
- une deuxième couche conductrice transparente 62, et
- au moins une couche de protection transparente 64.

En variante, la bande 34 comprend au moins une couche de décoration 66 positionnée sur le pourtour d'au moins une des couches électroluminescentes 36 et qui est intercalée entre les couches de protection transparentes 64, 65 ou entre la couche conductrice transparente 62 et la couche de protection transparente 64. La couche de décoration 66 a des formes déterminées pour dégager la marque électroluminescente 20 et pour camoufler les électrodes d'alimentation 60.

Selon une autre variante, une couche d'accrochage peut être prévue entre le support souple 48 et la première couche conductrice 56.

En variante, une couche intermédiaire permettant d'améliorer la cohésion et l'adhérence entre les autres couches de l'empilement est intercalée entre les couches 56, 58, 36, 62 et 64 de la bande de marquage.

La couche conductrice 56, la couche diélectrique 58, la couche électroluminescente 36, l'électrode d'alimentation 60, la couche conductrice transparente 62 et la couche de protection transparente 64 ne sont pas plus décrites car elles peuvent être identiques à celles précisées dans le document US-8.470.388.

A titre indicatif, la première couche conductrice 56, la couche diélectrique 58 et la couche électroluminescente 36 ont chacune une épaisseur comprise entre 0,02 et 0,05 mm, la deuxième couche conductrice transparente 62 a une épaisseur inférieure à 0, 015 mm et chaque couche de protection transparente 64 a une épaisseur de l'ordre de 0, 05 mm.

Selon l'invention, le procédé de réalisation d'une marque électroluminescente 20 sur une paroi extérieure 22 d'un aéronef comprend une première étape de superposition de différentes couches 56, 58, 36, 62 et 64 configurées pour obtenir la marque électroluminescente 20 souhaitée sur une première face 52 d'un support souple 48 distinct de l'aéronef 10 pour obtenir une bande de marquage 44 et une deuxième étape d'apposition de la bande de marquage 44 sur la paroi extérieure 22. Ainsi, les différentes couches 56, 58, 36, 62 et 64 configurées pour obtenir la marque électroluminescente 20 souhaitée sont fixées sur la paroi extérieure 22 de l'aéronef 10 en une seule étape et non successivement comme pour l'art antérieur, ce qui tend à réduire le temps d'intervention sur l'aéronef pour réaliser la marque électroluminescente 20.

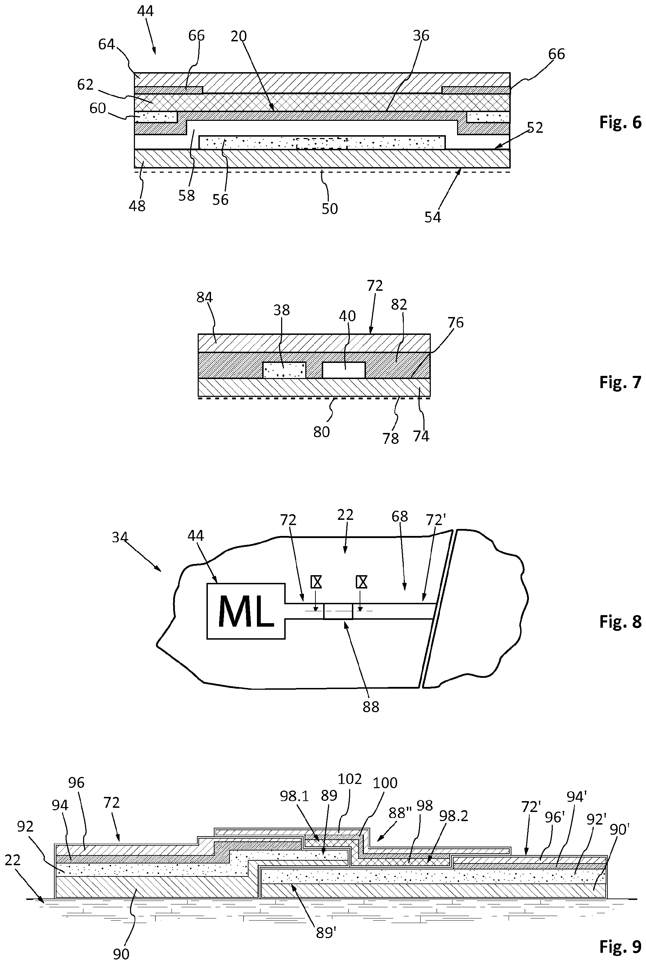

De préférence, la deuxième face 54 du support souple 48 est adhésive. Dans ce cas, comme illustré sur la figure 6, la bande de marquage 44 comprend un film de protection 50 configuré pour recouvrir la deuxième face 54 adhésive et être retiré afin de pouvoir appliquer la deuxième face 54 contre la paroi extérieure 22 de l'aéronef. Dans ce cas, le procédé comprend une étape de dépose du film de protection 50 contre la deuxième face 54 adhésive avant ou pendant la première étape et une étape de retrait du film de protection 50 avant la deuxième étape d'apposition.

Le fait de prévoir une deuxième face 54 adhésive permet de simplifier la deuxième étape d'apposition de la bande de marquage 44 sur la paroi extérieure 22 de l'aéronef. Le film de protection 50 permet de protéger cette deuxième face 54 adhésive de la première étape de fabrication de la bande de marquage 44 jusqu'à la deuxième étape d'apposition. Ainsi, la bande de marquage 44 peut être stockée et appliquée sur l'aéronef dans un laps de temps plus ou moins important après sa fabrication.

Selon une autre caractéristique de l'invention, le dispositif de marquage 34 comprend une extension 68 sous la forme d'une bande qui s'étend, sur la face extérieure 26E du panneau 26, de la bande de marquage 44 jusqu'au bord 28 du panneau, et sur la face intérieure 26I du panneau 26, du bord 28 jusqu'à un point 70 décalé par rapport au bord 28. Ainsi, l'extension 68 est disposée à cheval sur les faces intérieure 26I et extérieure 26E du panneau26 à partir du bord 28.

Selon une configuration, l'extension 68 est positionnée en aval selon la direction d'écoulement du flux d'air 24 par rapport à la bande de marquage 44.

Comme illustré sur la figure 5, l'extension 68 se présente sous la forme d'au moins une bande de connexion 72 qui comprend un support souple 74 avec une première face 76 supportant au moins un conducteur électrique 38, 40 et une deuxième face 78 configurée pour être plaquée sur la face extérieure 26E du panneau 26 et une portion de la face intérieure 26I du panneau 26.

Selon un mode de réalisation, la première face 76 supporte le premier conducteur électrique 38 et le deuxième conducteur électrique 40.

Le premier conducteur électrique 38 comprend une première extrémité reliée à la première couche conductrice 56 et une seconde extrémité reliée au système d'alimentation et de commande électrique 42. Le deuxième conducteur électrique 40 comprend une première extrémité reliée à l'électrode d'alimentation 60 et/ou à la deuxième couche conductrice transparente 64 et une seconde extrémité reliée au système d'alimentation et de commande électrique 42.

Selon l'invention, l'extension 68 permet de relier la marque électroluminescente 20 à un système d'alimentation électrique 42 de l'aéronef, en passant par un interstice 32 prévu entre le panneau 26 et un élément structurel 30 adjacent. Avantageusement, le système d'alimentation électrique 42 est situé dans une zone de l'aéronef qui n'est pas soumis au flux d'air 22 lorsque l'aéronef se déplace. Ainsi, il n'est pas nécessaire de percer la paroi extérieure 22 de l'aéronef à proximité de la marque (et donc dans le flux d'air) pour alimenter électriquement la marque électroluminescente 20 et les performances aérodynamiques de l'aéronef ne sont pas perturbées.

Selon une variante de réalisation, l'extension 68 est reliée au réseau de câbles électriques du système d'alimentation électrique 42 en utilisant un fluide conducteur, éventuellement recouvert d'une résine protectrice.

Selon une autre variante de réalisation, l'extension 68 est reliée au réseau de câbles électriques du système d'alimentation électrique 42 en utilisant un connecteur de type "crimp" dont une partie mâle est connectée au réseau de câbles électriques et une partie femelle est connectée à l'extension 68.

Avantageusement, la deuxième face 78 est adhésive. De préférence, préalablement à son apposition sur la paroi extérieure 22, la bande de connexion 72 comprend un film de protection 80, comme illustré sur la figure 7, configuré pour recouvrir la deuxième face 78 adhésive et pour être retiré afin de pouvoir appliquer la deuxième face 78 contre la paroi extérieure 22 de l'aéronef.

Selon un mode de réalisation visible sur la figure 5, la bande de connexion 72 comprend une couche de décoration 82 recouverte par au moins une couche de protection transparente 84. Selon une première variante, la bande de marquage 44 et la bande de connexion 72 ne forment qu'une unique et même bande. Selon cette variante visible sur les figures 2 et 3, le dispositif de marquage 34 comprend une unique bande de marquage qui comprend un corps 86 comportant la marque électroluminescente 20 et une extension 68 avec une longueur déterminée pour que l'extension 68 s'étende, sur la face extérieure 26E du panneau 26, de la bande de marquage 44 jusqu'au bord 28 du panneau, et sur la face intérieure 26I du panneau 26, à partir du bord 28.

Selon une autre variante, le dispositif de marquage 34 comprend au moins une bande de marquage 44 et au moins une bande de connexion 72 agencées pour assurer la continuité électrique entre des différents éléments conducteurs desdites bandes 44 et 72. Ces différentes bandes peuvent être juxtaposées, chevauchantes et/ou superposées.

Selon une autre variante visible sur les figures 8 et 9, l'extension 68 comprend au moins deux bandes de connexion 72, 72' permettant de relier la marque électroluminescente 20 au système d'alimentation électrique 42.

Sur la figure 9, on a illustré un agencement de trois bandes 72, 72', 88 apposées sur une paroi extérieure 22 de l'aéronef et agencées pour assurer la continuité électrique.

Selon un mode de réalisation, une première bande de connexion 72 comprend, de la paroi extérieure 22 vers l'extérieur, un premier support souple 90, une couche conductrice 92, une couche de décoration 94 et une couche de protection transparente 96. Une deuxième bande de connexion 72' comprend, de la paroi extérieure 22 vers l'extérieur, un premier support souple 90', une couche conductrice 92', une couche de décoration 94' et une couche de protection transparente 96'.

La première bande de connexion 72 comprend un premier bord 89 et la deuxième bande de connexion 72' comprend un deuxième bord 89'.

Selon une configuration visible sur la figure 9, le premier bord 89 de la première bande de connexion 72 recouvre le deuxième bord 89' de la deuxième bande de connexion 72'.

Quelle que soit la configuration, les premier et deuxième bords 89 et 89' sont proches.

Pour assurer la continuité électrique, la couche conductrice 92 de la première bande de connexion 72 n'est pas recouverte par la couche de décoration 94 et la couche de protection transparente 96 au niveau du premier bord 89. De même, la couche conductrice 92' de la deuxième bande de connexion 72' n'est pas recouverte par la couche de décoration 94' et la couche de protection transparente 96' au niveau du deuxième bord 89'.

La troisième bande 88 dite de raccordement est configurée pour assurer la continuité électrique entre les première et deuxième bandes de connexion 72 et 72'. Cette bande de raccordement 88 est disposée à cheval sur les première et deuxième bandes de connexion 72 et 72' et comprend une couche conductrice 98 dont un premier bord 98.1 est configuré pour venir en contact avec la couche conductrice 92 de la première bande de connexion 72 et dont un second bord 98.2 est configuré pour venir en contact avec la couche conductrice 92' de la deuxième bande de connexion 72'.

De préférence, l'épaisseur de la couche conductrice 98 de la bande de raccordement 88 (distance séparant le premier bord 98.1 du second bord 98.2) est inférieure ou égale à la distance séparant la couche de décoration 94 et la couche de protection transparente 96 de la première bande de connexion 72 et la couche de décoration 94' et la couche de protection transparente 96' de la deuxième bande de connexion 72'.

La bande de raccordement 88 comprend une couche de décoration 100 qui recouvre la couche conductrice 98 qui comprend une largeur assurant la continuité entre la couche de décoration 94 de la première bande de connexion 72 et la couche de décoration 94' de la deuxième bande de connexion 72'.

La bande de raccordement 88 comprend une couche de protection transparente 102 qui recouvre la couche de décoration 100. De préférence, la couche de protection transparente 102 s'étend au-delà de la couche de décoration 100 de part et d'autre de ladite couche de décoration 100 pour recouvrir la couche de protection transparente 96 de la première bande de connexion 72 et la couche de protection transparente 96' de la deuxième bande de connexion 72'.

Plus généralement, lorsque le dispositif de marquage 34 comprend des première et deuxième bandes de connexion 72, 72' comprenant chacune au moins un conducteur électrique 92, 92', il comprend également une bande de raccordement 88 disposée à cheval sur les première et deuxième bandes de connexion 72, 72' de manière à relier les éléments conducteurs desdites première et deuxième bandes de connexion 72, 72'. Avantageusement, chaque couche décrite précédemment se présente sous la forme d'un fluide liquide pouvant être appliqué par un procédé d'application de peinture classique, tel que l'application au spray ou au pinceau.

## Revendications

1. Procédé pour réaliser une marque électroluminescente (20) sur une paroi extérieure (22) d'un aéronef, ladite paroi extérieure (22) comprenant un panneau (26) avec une face extérieure (26E) et une face intérieure (26I) et étant délimité par un bord (28), **caractérisé en ce qu'**il comprend une étape de superposition de couches (56, 58, 36, 62 et 64) configurées pour réaliser la marque électroluminescente (20) sur une première face (52) d'un support souple (48) distinct de l'aéronef (10) pour obtenir une bande de marquage (44), et une étape d'apposition de la bande de marquage (44) sur la paroi extérieure (22) de l'aéronef (10) et une étape d'apposition d'au moins une bande de connexion (72) sur la face extérieure (26E) du panneau (26) jusqu'au bord (28) du panneau pour relier la marque électroluminescente (20) à un système d'alimentation et de commande électrique (42) positionné à l'intérieur de l'aéronef, le bord (28) du panneau étant disposé en aval par rapport à la marque électroluminescente (20) selon la direction d'écoulement d'un flux d'air (24) qui s'écoule à l'extérieur de l'aéronef lorsque l'aéronef est en vol.

2. Procédé selon la revendication 1, **caractérisé en ce que** la bande connexion (72) s'étend, sur la face extérieure (26E) du panneau (26), de la bande de marquage (44) jusqu'au bord (28) du panneau, et sur la face intérieure (26I) du panneau (26), du bord (28) jusqu'à un point (70) décalé par rapport au bord (28).

3. Procédé selon la revendication 1 ou 2, **caractérisé en ce que** la bande de marquage (44) comprend une deuxième face (54) adhésive configurée pour être plaquée contre la paroi extérieure (22) et **en ce que** le procédé comprend une étape de dépose d'un film de protection (50) contre la deuxième face (54) adhésive et une étape de retrait du film de protection (50) avant l'étape d'apposition.

4. Aéronef comprenant un dispositif de marquage comportant une bande de marquage (44) comprenant une marque électroluminescente (20), **caractérisé en ce que** la bande de marquage comprend un support souple (48) avec une première face (52) qui comporte une superposition de couches (56, 58, 36, 62 et 64) configurées pour réaliser la marque électroluminescente (20) et une deuxième face (54) configurée pour être plaquée contre une face extérieure (26E) d'un panneau (26) d'une paroi extérieure (22) de l'aéronef ainsi qu'une extension (68) configurée pour s'étendre sur la face extérieure (26E) du panneau (26) jusqu'à un bord (28) du panneau (26) afin de relier la marque électroluminescente (20) à un système d'alimentation et de commande électrique (42) positionné à l'intérieur de l'aéronef, le bord (28) du panneau étant disposé en aval par rapport à la marque électroluminescente (20) selon la direction d'écoulement d'un flux d'air (24) qui s'écoule à l'extérieur de l'aéronef lorsque l'aéronef est en vol.

5. Aéronef selon la revendication 4, **caractérisée en ce que** l'extension (68) est configurée pour s'étendre, sur la face extérieure (26E) du panneau (26), de la bande de marquage (44) jusqu'au bord (28) du panneau, et sur la face intérieure (26I) du panneau (26), du bord (28) jusqu'à un point (70) décalé par rapport au bord (28).

6. Aéronef selon la revendication 4 ou 5, **caractérisée en ce que** la deuxième face (54) est adhésive et **en ce que** la bande de marquage (22) comprend un film de protection (50) recouvrant la deuxième face (54) adhésive.

7. Aéronef selon l'une quelconque des revendications 4 à 6, **caractérisé en ce que** la dispositif de marquage comprend au moins une bande de connexion (72) pour relier la bande de marquage (44) à un système d'alimentation et de commande électrique (42) positionné à l'intérieur de l'aéronef, ladite bande de connexion (72) étant configurée pour s'étendre sur la face extérieure (26E) du panneau (26), de la bande de marquage (44) jusqu'à un bord (28) du panneau (26).

8. Aéronef selon la revendication 7, **caractérisé en ce que** le dispositif de marquage comprend au moins une première et une deuxième bandes de connexion (72, 72') comprenant chacune au moins un conducteur électrique (92, 92') et une bande de raccordement (88) disposée à cheval sur les première et deuxième bandes de connexion (72, 72') de manière à relier les éléments conducteurs (92, 92') desdites première et deuxième bandes de connexion (72, 72').

## Patentansprüche

1. Verfahren zur Herstellung einer Elektrolumineszenzmarkierung (20) auf einer Außenwand (22) eines Luftfahrzeugs, wobei die Außenwand (22) ein Beplankungsfeld (26) mit einer Außenseite (26E) und einer Innenseite (26I) umfasst und von einem Rand (28) begrenzt wird, **dadurch gekennzeichnet, dass** es einen Schritt der Übereinanderlagerung von Schichten (56, 58, 36, 62 und 64), die dafür ausgelegt sind, die Elektrolumineszenzmarkierung (20) auf einer ersten Seite (52) eines von dem Luftfahrzeug (10) getrennten flexiblen Trägers (48) herzustellen, um ein Markierungsband (44) zu erhalten, und einen Schritt der Anbringung des Markierungsbandes (44) auf der Außenwand (22) des Luftfahrzeugs (10) und einen Schritt der Anbringung wenigstens eines Verbindungsbandes (72) auf der Außenseite (26E) des Beplankungsfeldes (26) bis zum Rand (28) des Beplankungsfeldes, um die Elektrolumineszenzmarkierung (20) mit einem elektrischen Stromversorgungs- und Steuerungssystem (42) zu verbinden, das im Inneren des Luftfahrzeugs positioniert ist, umfasst, wobei der Rand (28) des Beplankungsfeldes in der Strömungsrichtung eines Luftstroms (24), der an der Außenseite des Luftfahrzeugs entlangströmt, wenn das Luftfahrzeug fliegt, stromabwärts in Bezug auf die Elektrolumineszenzmarkierung (20) angeordnet ist.

2. Verfahren nach Anspruch 1, **dadurch gekennzeichnet, dass** sich das Verbindungsband (72) auf der Außenseite (26E) des Beplankungsfeldes (26) vom Markierungsband (44) bis zum Rand (28) des Beplankungsfeldes erstreckt, und auf der Innenseite (26I) des Beplankungsfeldes (26) vom Rand (28) bis zu einem Punkt (70), der bezüglich des Randes (28) versetzt ist.

3. Verfahren nach Anspruch 1 oder 2, **dadurch gekennzeichnet, dass** das Markierungsband (44) eine klebende zweite Seite (54) umfasst, die dafür ausgelegt ist, gegen die Außenwand (22) gedrückt zu werden, und dadurch, dass das Verfahren einen Schritt der Anbringung einer Schutzfolie (50) auf der klebenden zweiten Seite (54) und einen Schritt der Entfernung der Schutzfolie (50) vor dem Schritt der Anbringung umfasst.

4. Luftfahrzeug, welches eine Markierungsvorrichtung umfasst, die ein Markierungsband (44) aufweist, das eine Elektrolumineszenzmarkierung (20) umfasst, **dadurch gekennzeichnet, dass** das Markierungsband einen flexiblen Träger (48) mit einer ersten Seite (52), welche eine Übereinanderlagerung von Schichten (56, 58, 36, 62 und 64) aufweist, die dafür ausgelegt sind, die Elektrolumineszenzmarkierung (20) herzustellen, und einer zweiten Seite (54), die dafür ausgelegt ist, gegen eine Außenseite (26E) eines Beplankungsfeldes (26) einer Außenwand (22) des Luftfahrzeugs gedrückt zu werden, umfasst, sowie eine Verlängerung (68), die dafür ausgelegt ist, sich auf der Außenseite (26E) des Beplankungsfeldes (26) bis zu einem Rand (28) des Beplankungsfeldes (26) zu erstrecken, um die Elektrolumineszenzmarkierung (20) mit einem elektrischen Stromversorgungs- und Steuerungssystem (42) zu verbinden, das im Inneren des Luftfahrzeugs positioniert ist, wobei der Rand (28) des Beplankungsfeldes in der Strömungsrichtung eines Luftstroms (24), der an der Außenseite des Luftfahrzeugs entlangströmt, wenn das Luftfahrzeug fliegt, stromabwärts in Bezug auf die Elektrolumineszenzmarkierung (20) angeordnet ist.

5. Luftfahrzeug nach Anspruch 4, **dadurch gekennzeichnet, dass** die Verlängerung (68) dafür ausgelegt ist, sich auf der Außenseite (26E) des Beplankungsfeldes (26) vom Markierungsband (44) bis zum Rand (28) des Beplankungsfeldes und auf der Innenseite (26I) des Beplankungsfeldes (26) vom Rand (28) bis zu einem Punkt (70), der bezüglich des Randes (28) versetzt ist, zu erstrecken.

6. Luftfahrzeug nach Anspruch 4 oder 5, **dadurch gekennzeichnet, dass** die zweite Seite (54) klebend ist, und dadurch, dass das Markierungsband (22) eine Schutzfolie (50) umfasst, welche die klebende zweite Seite (54) bedeckt.

7. Luftfahrzeug nach einem der Ansprüche 4 bis 6, **dadurch gekennzeichnet, dass** die Markierungsvorrichtung wenigstens ein Verbindungsband (72) umfasst, um das Markierungsband (44) mit einem elektrischen Stromversorgungs- und Steuerungssystem (42) zu verbinden, das im Inneren des Luftfahrzeugs positioniert ist, wobei das Verbindungsband (72) dafür ausgelegt ist, sich auf der Außenseite (26E) des Beplankungsfeldes (26) vom Markierungsband (44) bis zu einem Rand (28) des Beplankungsfeldes (26) zu erstrecken.

8. Luftfahrzeug nach Anspruch 7, **dadurch gekennzeichnet, dass** die Markierungsvorrichtung wenigstens ein erstes und ein zweites Verbindungsband (72, 72'), die jeweils wenigstens einen elektrischen Leiter (92, 92') umfassen, und ein Anschlussband (88), das rittlings auf dem ersten und dem zweiten Verbindungsband (72, 72') angeordnet ist, derart, dass es die leitenden Elemente (92, 92') des ersten und zweiten Verbindungsbandes (72, 72') verbindet, umfasst.

## Claims

1. Method for making an electroluminescent marking (20) on an exterior wall (22) of an aircraft, said exterior wall (22) comprising a panel (26) with an exterior face (26E) and an interior face (261) and being bounded by an edge (28), **characterized in that** it involves a step of superpositioning of layers (56, 58, 36, 62 and 64) designed to produce the electroluminescent marking (20) on a first face (52) of a flexible backing (48) distinct from the aircraft (10) to obtain a marking tape (44), and a step of affixing the marking tape (44) to the exterior wall (22) of the aircraft (10) and a step of affixing at least one connection tape (72) to the exterior face (26E) of the panel (26) as far as the edge (28) of the panel to connect the electroluminescent marking (20) to an electrical control and power supply system (42) positioned inside the aircraft, the edge (28) of the panel being disposed downstream from the electroluminescent marking (20) in the direction of movement of an air flow (24) which moves on the outside of the aircraft when the aircraft is in flight.

2. Method according to Claim 1, **characterized in that** the connection tape (72) extends on the exterior face (26E) of the panel (26) from the marking tape (44) to the edge (28) of the panel (26) and on the interior face (261) of the panel (26) from the edge (28) to a point (70) which is offset relative to the edge (28).

3. Method according to Claim 1 or 2, **characterized in that** the marking tape (44) comprises a second adhesive face (54) designed to be pasted against the exterior wall (22) and the method involves a step of depositing a protection film (50) against the second adhesive face (54) and a step of removal of the protection film (50) prior to the step of affixing.

4. Aircraft comprising a marking device comprising a marking tape (44) having an electroluminescent marking (20), **characterized in that** the marking tape comprises a flexible backing (48) with a first face (52) having a superpositioning of layers (56, 58, 36, 62 and 64) designed to produce the electroluminescent marking (20) and a second face (54) designed to be pasted against an exterior face (26E) of a panel (26) of an exterior wall (22) of the aircraft as well as an extension (68) designed to extend on the exterior face (26E) of the panel (26) as far as one edge (28) of the panel (26) in order to connect the electroluminescent marking (20) to an electrical control and power supply system (42) positioned inside the aircraft, the edge (28) of the panel being disposed downstream from the electroluminescent marking (20) in the direction of movement of an air flow (24) which moves on the outside of the aircraft when the aircraft is in flight.

5. Aircraft according to Claim 4, **characterized in that** the extension (68) is designed to extend on the exterior face (26E) of the panel (26) from the marking tape (44) to the edge (28) of the panel (26) and on the interior face (261) of the panel (26) from the edge (28) to a point (70) which is offset relative to the edge (28).

6. Aircraft according to Claim 4 or 5, **characterized in that** the second face (54) is adhesive and the marking tape (22) comprises a protection film (50) covering the second adhesive face (54).

7. Aircraft according to any one of Claims 4 to 6, **characterized in that** the marking device comprises at least one connection tape (72) for connecting the marking tape (44) to an electrical control and power supply system (42) positioned inside the aircraft, said connection tape (72) being configured to extend on the exterior face (26E) of the panel (26) from the marking tape (44) to one edge (28) of the panel (26).

8. Aircraft according to Claim 7, **characterized in that** the marking device comprises at least one first and one second connection tape (72, 72'), each of them comprising at least one electrical conductor (92, 92') and a junction tape (88) straddling the first and second connection tapes (72, 72') so as to join the conductor elements (92, 92') of said first and second connection tapes (72, 72').
